# EUROPEAN PATENT APPLICATION

(11) **EP 4 443 675 A1**
(43) Date of publication of application: **09.10.2024**
(21) Application number: 22931753.2
(22) Date of filing: 19.10.2022
(51) Int. Cl.: H01S 5/40, G02B 6/26

(54) **EXTERNAL OPTICAL INJECTION LOCKING LASER**

(30) Priority: 16.03.2022 CN 202210260097
(71) Applicant: Suzhou Institute of Nano-tech and Nano-bionics (SINANO) Chinese Academy of Sciences, Suzhou, Jiangsu 215123 (CN)
(72) Inventor: ZHANG, Ruiying, Suzhou, Jiangsu 215123 (CN); ZHANG, Ben, Suzhou, Jiangsu 215123 (CN)
(74) Representative: Cabinet Laurent & Charras
(86) International application number: PCT/CN2022/126129
(87) International publication number: WO 2023/173738

(57) **Abstract**

Provided is an external optical injection locked laser. The external optical injection locked laser includes a master laser (1), an input-output waveguide (3) and a slave laser (2) that are formed on the same substrate (9). The master laser (1) is configured to emit a laser to the input-output waveguide (3). The input-output waveguide (3) is configured to inject the laser emitted by the master laser (1) into the slave laser (2) in a manner of directional coupling and output the lasers emitted by the master laser (1) and the slave laser (2). The slave laser (2) includes a waveguide resonant cavity. The slave laser (2) is configured to cohere a laser generated by the slave laser (2) with the injected laser of the master laser (1) and emit a laser. The laser emitted by the slave laser (2) is locked by the master laser (1).

## Description

This application claims priority to Chinese Patent Application No. 202210260097.4 filed with the China National Intellectual Property Administration (CNIPA) on Mar. 16, 2022, the disclosure of which is incorporated herein by reference in its entirety.

### TECHNICAL FIELD

The present application relates to semiconductor optoelectronic technology, for example, an external optical injection locked laser.

### BACKGROUND

Optical injection locked (OIL) technique, which can be used for narrowing down the linewidth of a laser, increasing a modulation bandwidth, decreasing a chirp, and selecting and amplifying a signal and can be used for coherent detection, a lidar, laser ranging, a high-speed directly modulated laser, an optical amplifier, a phase-sensitive amplifier, dense wavelength-division multiplexing technology, the generation of a radio frequency waveform and the synthesis of an optical waveform, is one of the main means for improving the performance of a modern optoelectronic device and plays a vital role in national defense and national economic construction. External optical injection locking is one of the main means for implementing the above performance. Since external optical injection needs unidirectional injection, an optical isolator is necessary equipment for a system. A method for implementing the external optical injection locking includes two main solutions: (1) an injection locking distributed feedback (DFB) laser of a discrete fiber optic system; and (2) an injection locking ring cavity laser of a discrete fiber optic system. The injection locking function in the above solutions is implemented based on discrete components, the connection between the discrete components is implemented through a fiber, and the implementation of related performances is ensured by utilizing devices with a large volume such as an erbium-doped fiber amplifier, a polarization controller and a bulk optical isolator. In this manner, the entire external optical injection locking system has a loose structure, a large volume and high energy consumption and cannot be prepared in batches, which is difficult to meet requirements for a small volume, low power consumption, a low cost and mass market application in the application field of high-performance optoelectronic devices.

### SUMMARY

The present application provides a chip-level external optical injection locked laser to realize a compact structure, a small volume, good device stability and reliability, strong resistance to a harsh environment, good device uniformity and a low cost.

The present application provides an external optical injection locked laser. The external optical injection locked laser includes a master laser, an input-output waveguide and a slave laser that are formed on the same substrate.

The master laser is configured to emit a laser to the input-output waveguide.

The input-output waveguide is configured to inject the laser emitted by the master laser into the slave laser.

The slave laser includes a waveguide resonant cavity, the slave laser is configured to emit a laser when the laser emitted by the master laser is injected into the slave laser, and the laser emitted by the slave laser is locked by the master laser.

### BRIEF DESCRIPTION OF DRAWINGS

FIG. 1 is a top view of an external optical injection locked laser according to an embodiment of the present application.
FIG. 2 is a top view of another external optical injection locked laser according to an embodiment of the present application.
FIG. 3 is a top view of another external optical injection locked laser according to an embodiment of the present application.
FIG. 4 is a top view of another external optical injection locked laser according to an embodiment of the present application.
FIG. 5 is a sectional view taken along AA' in FIG. 4.
FIG. 6 is a cross-sectional view of an external optical injection locked laser according to an embodiment of the present application.
FIG. 7 is a structure diagram of a first total reflection mirror according to an embodiment of the present application.
FIG. 8 is a top view of another external optical injection locked laser according to an embodiment of the present application.

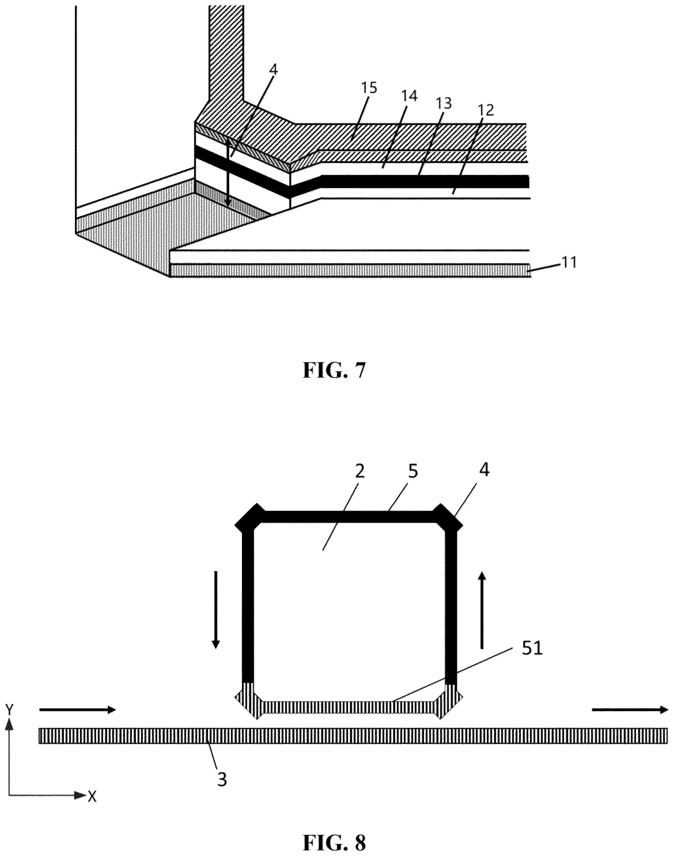

FIG. 8 is a top view of another external optical injection locked laser according to an embodiment of the present application.

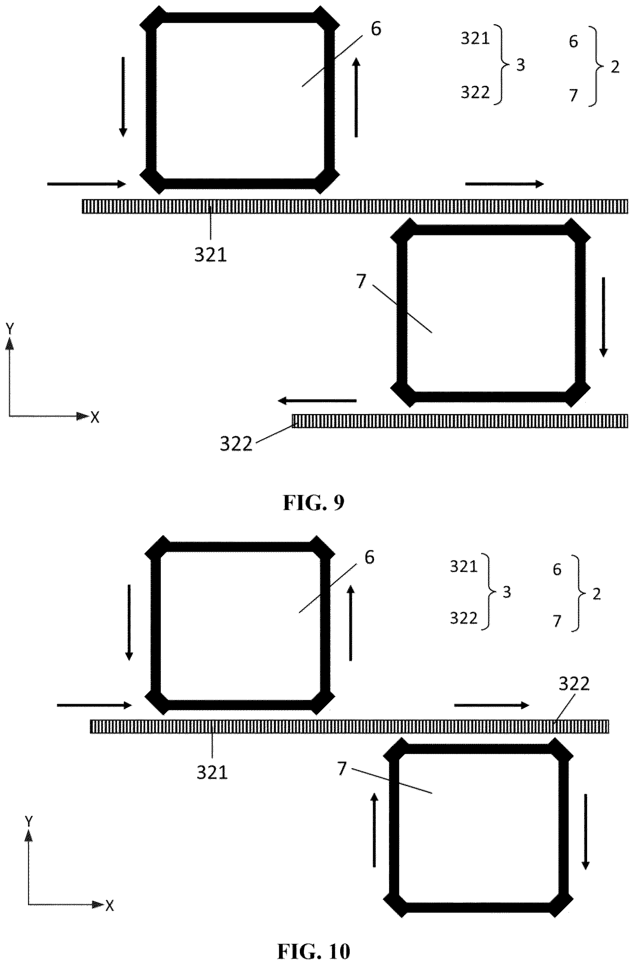

FIG. 9 is a top view of another external optical injection locked laser according to an embodiment of the present application.
FIG. 10 is a top view of another external optical injection locked laser according to an embodiment of the present application.

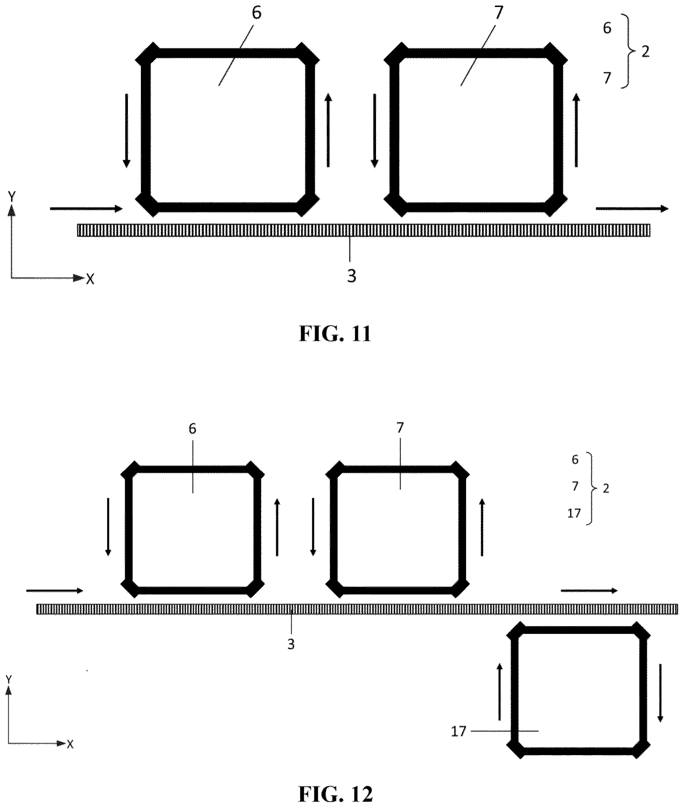

FIG. 11 is a top view of another external optical injection locked laser according to an embodiment of the present application.
FIG. 12 is a top view of another external optical injection locked laser according to an embodiment of the present application.

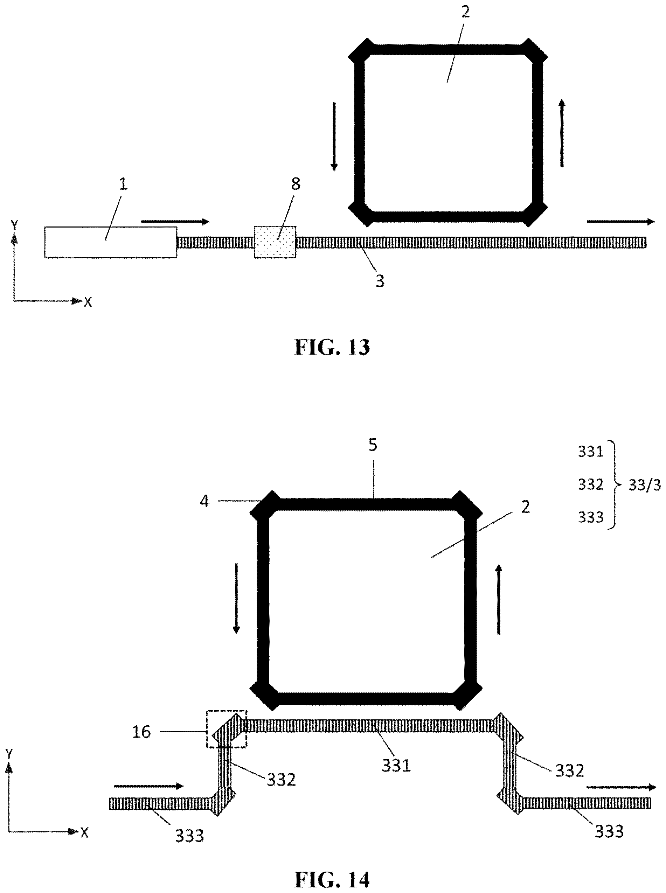

FIG. 13 is a top view of another external optical injection locked laser according to an embodiment of the present application.
FIG. 14 is a top view of another external optical injection locked laser according to an embodiment of the present application.

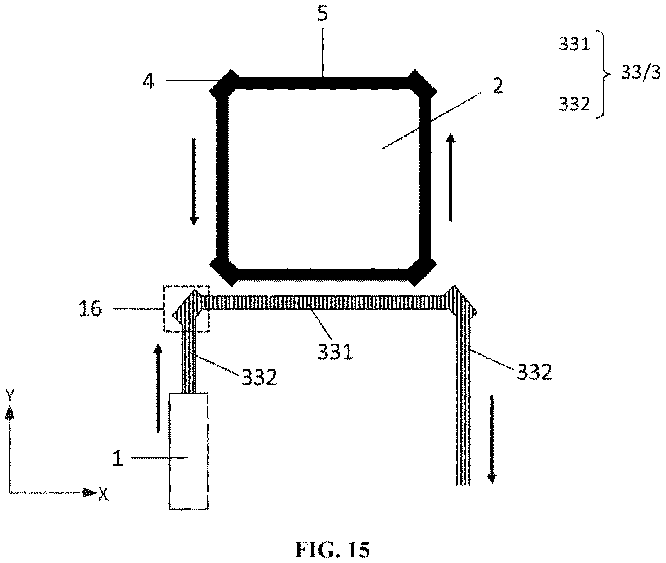

FIG. 15 is a top view of another external optical injection locked laser according to an embodiment of the present application.

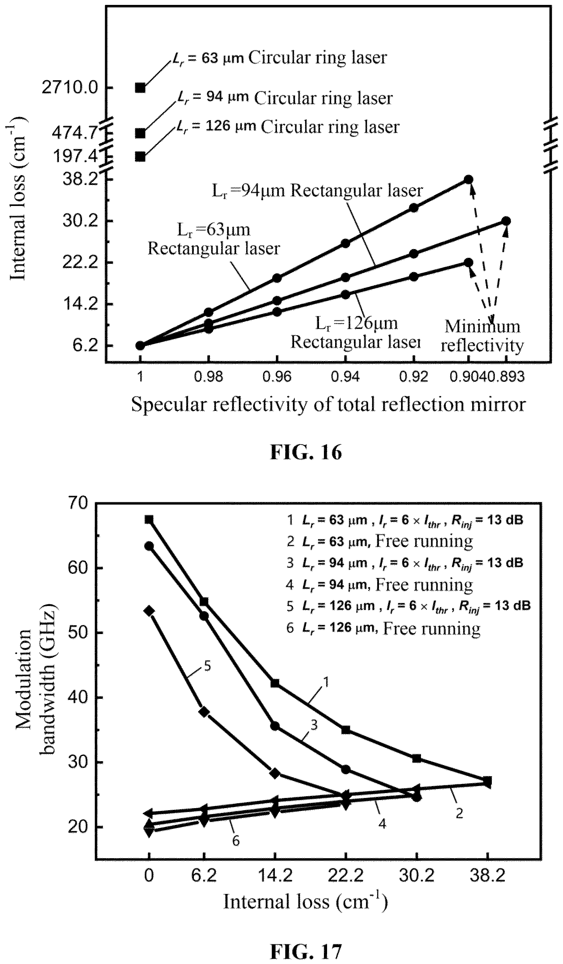

FIG. 16 is a diagram illustrating a relationship of internal loss varying with a length of a resonant cavity of a rectangular cavity laser and the specular reflectivity of a total reflection mirror according to an embodiment of the present application.
FIG. 17 is a diagram illustrating a relationship of a modulation bandwidth varying with a length of a resonant cavity of a ring laser and internal loss according to an embodiment of the present application.

### DETAILED DESCRIPTION

The present application is described below in conjunction with drawings and embodiments. Specific embodiments described herein are merely intended to explain the present application. For ease of description, only parts related to the present application are illustrated in the drawings.

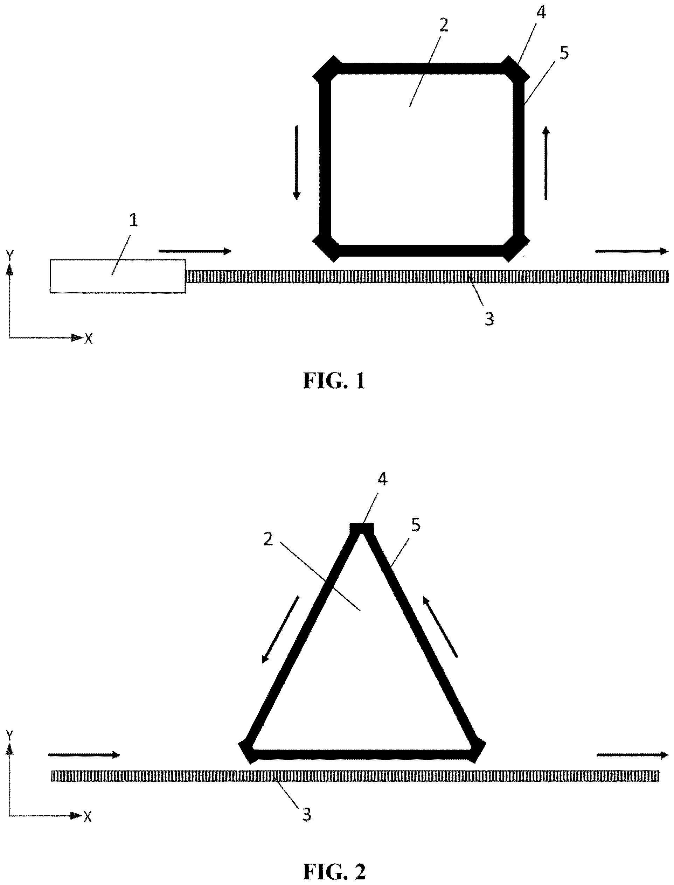

FIG. 1 is a top view of an external optical injection locked laser according to an embodiment of the present application. Referring to FIG. 1, the external optical injection locked laser includes a master laser 1, an input-output waveguide 3 and a slave laser 2 that are formed on the same substrate (not shown in FIG. 1). The master laser 1 is configured to emit a laser to the input-output waveguide 3. The input-output waveguide 3 is configured to inject the laser emitted by the master laser 1 into the slave laser 2. The slave laser 2 includes a waveguide resonant cavity, the slave laser 2 is configured to emit a laser in a case where the laser emitted by the master laser 1 is injected into the slave laser 2, and the laser emitted by the slave laser 2 is locked by the master laser 1. For example, the input-output waveguide 3 is configured to inject the laser emitted by the master laser 1 into the slave laser 2 in a directional coupling manner and output the lasers emitted by the master laser 1 and the slave laser 2, the slave laser 2 is configured to cohere a laser generated by the slave laser 2 with the injected laser of the master laser 1 and then emit the laser locked by the master laser 1. The laser emitted by the master laser 1 is injected into the slave laser 2 through the input-output waveguide 3 so that the laser emitted by the slave laser 2 is locked by the master laser 1 and a lasing wavelength of the slave laser 2 is consistent with that of the master laser 1, and the laser output by the slave laser 2 and the laser emitted by the master laser 1 are coupled and output by the input-output waveguide 3.

In an embodiment, the slave laser 2 includes a waveguide resonant cavity with a polygonal closed structure, the waveguide resonant cavity includes multiple first total reflection mirrors 4 and multiple first straight waveguides 5, and the first total reflection mirror 4 is located between two adjacent first straight waveguides 5. Since the waveguide resonant cavity formed by the multiple first total reflection mirrors 4 and the multiple first straight waveguides 5 has the polygonal closed structure, the first straight waveguide 5 is located between two adjacent first total reflection mirrors 4. The first total reflection mirror 4 is configured to reflect a laser transmitted in one first straight waveguide 5 to the other first straight waveguide 5.

In an embodiment, the waveguide resonant cavity may also have a circular ring structure or a runway structure.

The embodiment of the present application provides the external optical injection locked laser, in which the master laser 1, the input-output waveguide 3 and the slave laser 2 are disposed on the same substrate. Compared with a discrete external optical injection locked laser system, the chip-level laser has the following advantages: (1) the structure is compact, and the volume is small; (2) the materials are of the same type, the thermal and mechanical properties are consistent, and therefore, the device stability and reliability are good, the resistance to a harsh environment is strong; and (3) the design and preparation are unified, the device uniformity is good, and the cost is low. In addition, for the slave laser 2 with the polygonal resonant cavity, the loss of the first straight waveguide 5 is irrelevant to the dimension, and the loss of the first total reflection mirror 4 is inversely proportional to the circumference. In this manner, the loss of the waveguide resonant cavity of the slave laser 2 is significantly reduced, and the dependence of the loss of the waveguide resonant cavity on the dimension is significantly reduced. Moreover, the polygonal waveguide resonant cavity has transmission characteristics of a traveling wave in a ring cavity, and no optical isolator is needed so that unidirectional injection locking becomes possible and the chip-level external optical injection locked laser becomes possible, thereby laying a foundation for the actual application of the chip-level external optical injection locked laser in the fields of high-speed directly modulated lasers, narrow linewidth lasers and signal selection and amplification.

The master laser 1 is a single longitudinal mode semiconductor laser and performs unidirectional injection locking on a counterclockwise (CCW) optical mode of the slave laser 2. The master laser 1 may be a DFB laser, a distributed Bragg reflector (DBR) laser or a laser coupled to a passive loop as long as the master laser 1 is a laser whose lasing mode includes a single longitudinal mode and a fundamental transverse mode.

Referring to FIG. 1, the waveguide resonant cavity is quadrilateral. The laser emitted by the master laser 1 is projected into the input-output waveguide 3 and coupled into the slave laser 2 through the input-output waveguide 3. In the arrow direction shown in FIG. 1, the laser emitted by the master laser 1 passes through four first straight waveguides 5 of the waveguide resonant cavity anticlockwise in sequence to be coupled into the input-output waveguide 3 and continues propagating along the input-output waveguide 3.

In another embodiment, the waveguide resonant cavity may also be a polygon of another shape. A triangle and a hexagon are used as examples below. However, it is not limited to this case. The number of sides in the polygon of the waveguide resonant cavity may be determined according to an actual requirement.

FIG. 2 is a top view of another external optical injection locked laser according to an embodiment of the present application. Referring to FIG. 2, the waveguide resonant cavity is triangular. The laser emitted by the master laser 1 is projected into the input-output waveguide 3 and coupled into the slave laser 2 by the input-output waveguide 3. In the arrow direction shown in FIG. 2, the laser emitted by the master laser 1 passes through three first straight waveguides 5 of the waveguide resonant cavity anticlockwise in sequence to be coupled into the input-output waveguide 3 and continues propagating along the input-output waveguide 3.

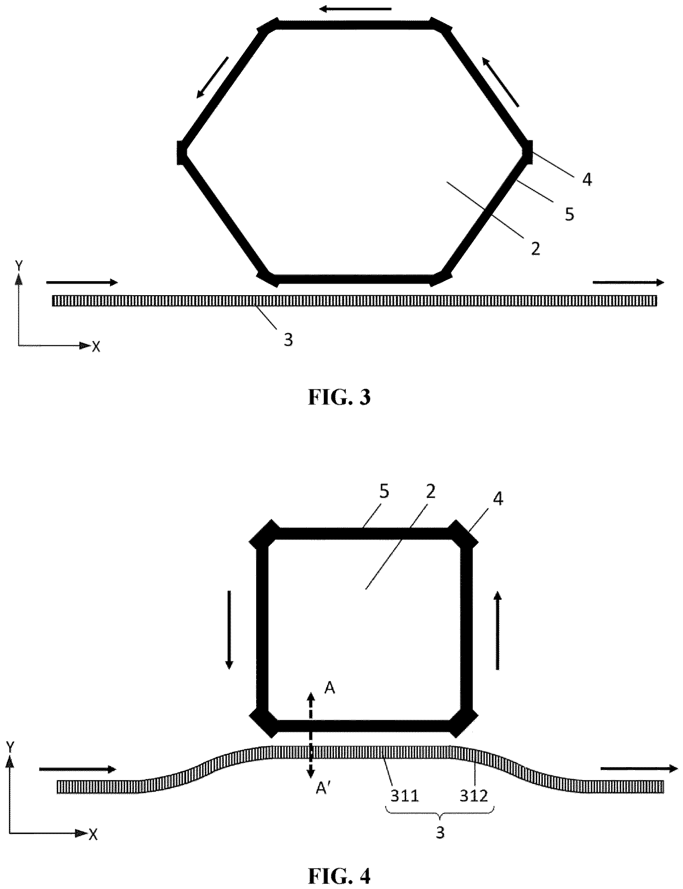

FIG. 3 is a top view of another external optical injection locked laser according to an embodiment of the present application. Referring to FIG. 3, the waveguide resonant cavity is hexagonal. The laser emitted by the master laser 1 is projected into the input-output waveguide 3 and coupled into the slave laser 2 by the input-output waveguide 3. In the arrow direction shown in FIG. 3, the laser emitted by the master laser 1 passes through six first straight waveguides 5 of the waveguide resonant cavity anticlockwise in sequence to be coupled into the input-output waveguide 3 and continues propagating along the input-output waveguide 3.

For example, referring to FIGS. 1 to 3, one first straight waveguide 5 of the slave laser 2 is coupled to the input-output waveguide 3.

In an embodiment, multiple first straight waveguides 5 of the slave laser 2 are coupled to the input-output waveguide 3.

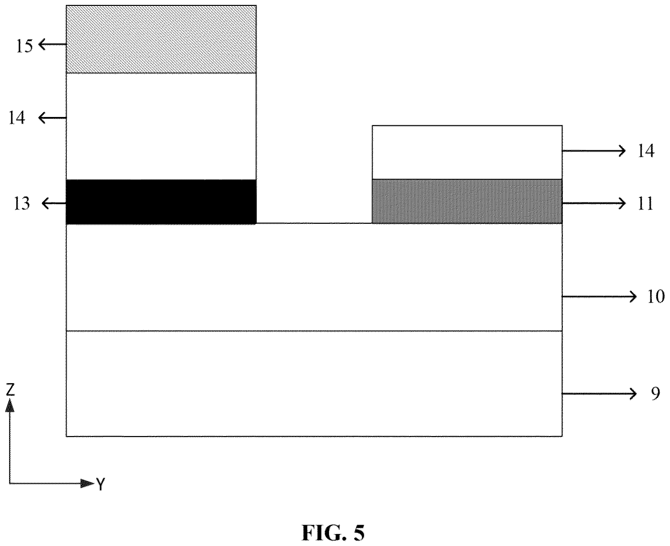

FIG. 4 is a top view of another external optical injection locked laser according to an embodiment of the present application. FIG. 5 is a sectional view taken along AA' in FIG. 4. The input-output waveguide 3 includes a first waveguide portion 311 and a second waveguide portion 312. The input-output waveguide 3 extends in an X direction. In a projection perpendicular to the substrate (that is, along a Z direction) and in a direction (that is, in a Y direction) perpendicular to the extension direction of the input-output waveguide 3, the first waveguide portion 311 overlaps the first straight waveguide 5, and the second waveguide portion 312 overlaps the first total reflection mirror 4. That is, in the projection perpendicular to the substrate, the first waveguide portion 311 corresponds to the first straight waveguide 5, and the second waveguide portion 312 corresponds to the first total reflection mirror 4. In the projection perpendicular to the substrate and in the direction perpendicular to the extension direction of the input-output waveguide 3, a distance between the first waveguide portion 311 and the waveguide resonant cavity is less than a distance between the second waveguide portion 312 and the waveguide resonant cavity. In the embodiment of the present application, a portion of one first straight waveguide 5 of the slave laser 2 is coupled to the input-output waveguide 3. The input-output waveguide 3 is a bent waveguide, which forms a protrusion toward the slave laser 2 at a position close to the slave laser 2. In this manner, the distance between the first waveguide portion 311 and the first straight waveguide 5 corresponding to the first waveguide portion 311 is shorter, and the distance between the second waveguide portion 312 and the first total reflection mirror 4 corresponding to the second waveguide portion 312 is longer. The bent input-output waveguide 3 is used to bypass a deeply etched surface of the first total reflection mirror 4 and implement a larger coupling coefficient. Moreover, it is ensured that the first total reflection mirror 4 obtains a high reflectivity.

In a vertical coupling structure, the first waveguide portion 311 (and the second waveguide portion 312) and the first straight waveguide 5 are located in different layers, and the first total reflection mirror 4 is a plane perpendicular to the substrate. The first waveguide portion 311 overlaps the first straight waveguide 5 in the direction (that is, the Z direction) perpendicular to the substrate. In a parallel coupling structure, the first waveguide portion 311 does not overlap the first straight waveguide 5 in the direction perpendicular to the substrate. As shown in FIG. 4, the overlap between the first waveguide portion 311 and the first straight waveguide 5 is in the Y direction, and the overlap between the second waveguide portion 312 and the first total reflection mirror 4 is also in the Y direction. The corresponding relationship between the first waveguide portion 311 and the first straight waveguide 5 refers to a corresponding relationship along the Y direction in the X-Y plane, and the corresponding relationship between the second waveguide portion 312 and the first total reflection mirror 4 also refers to a corresponding relationship along the Y direction in the X-Y plane.

In an embodiment, a geometric center of the waveguide resonant cavity may be used as a start point for distance calculation. In another embodiment, a first straight waveguide 5 that is in the waveguide resonant cavity and closest to the input-output waveguide 3 may also be used as the start point for the distance calculation.

In an embodiment, the first waveguide portion 311 and the second waveguide portion 312 are located within a length range of a first straight waveguide 5 between two adjacent first total reflection mirrors 4.

Referring to FIGS. 4 and 5, the external optical injection locked laser includes a substrate 9, a buffer layer 10, a passive waveguide layer 11 (or an active waveguide layer 13), a cladding layer 14 and a contact layer 15 that are stacked in sequence. The active waveguide layer 13 of the waveguide resonant cavity and the passive waveguide layer 11 of the input-output waveguide 3 are disposed in the same layer. The first straight waveguide 5 includes the buffer layer 10, the active waveguide layer 13 and the cladding layer 14, the input-output waveguide 3 includes the buffer layer 10, the passive waveguide layer 11 and the cladding layer 14, the passive waveguide layer 11 and the active waveguide layer 13 are disposed in the same layer, the first straight waveguide 5 and the input-output waveguide 3 are disposed in the same layer, and the slave laser 2 is coupled in parallel to the input-output waveguide 3.

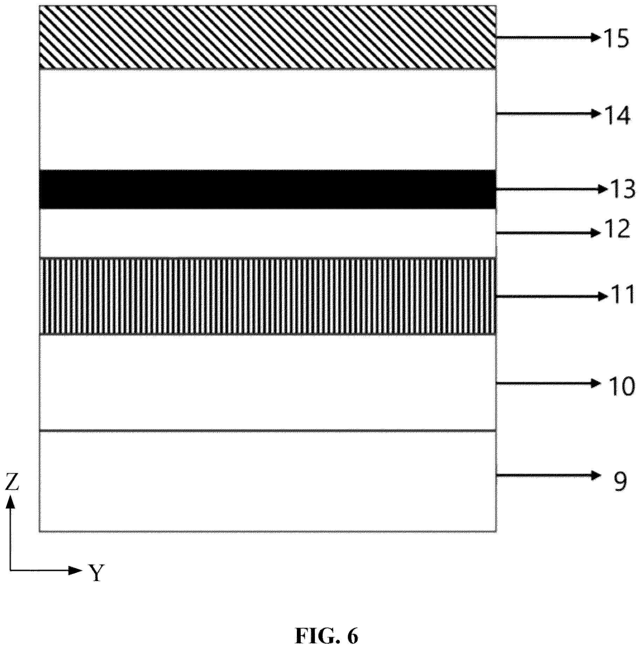

FIG. 6 is a cross-sectional view of an external optical injection locked laser according to an embodiment of the present application. Referring to FIG. 6, the external optical injection locked laser includes a substrate 9, a buffer layer 10, a passive waveguide layer 11, an isolation layer 12, an active waveguide layer 13, a cladding layer 14 and a contact layer 15 that are stacked in sequence. In the direction perpendicular to the substrate, the input-output waveguide 3 is located between the substrate 9 and the first straight waveguide 5. The first straight waveguide 5 includes part of the isolation layer 12, the active waveguide layer 13 and the cladding layer 14, the input-output waveguide 3 includes the buffer layer 10, the passive waveguide layer 11 and part of the isolation layer 12, the passive waveguide layer 11 and the active waveguide layer 13 are stacked, and the first straight waveguide 5 and the input-output waveguide 3 are stacked. In the Z direction, the first straight waveguide 5 overlaps the input-output waveguide 3, and one first straight waveguide 5 of the slave laser 2 is vertically coupled to the input-output waveguide 3.

The waveguide resonant cavity has a polygonal closed structure and includes multiple first straight waveguides 5. All the first straight waveguides 5 include the same layer structure. In an embodiment, as shown in FIG. 4, all the first straight waveguides 5 each include part of the isolation layer 12, the active waveguide layer 13 and the cladding layer 14, and all the first straight waveguides 5 are made of the same material.

For example, referring to FIGS. 5 and 6, the substrate 9 includes silicon (Si), indium phosphide (InP), gallium arsenide (GaAs) or gallium nitride (GaN). A laser using InP, GaAs and GaN as the substrate is generally a monolithic integrated external optical injection locked laser. According to integration technique, a laser using Si as the substrate is generally a hybrid integrated external optical injection locked laser such as a heterogeneous integrated external optical injection locked laser or a butt coupling external optical injection locked laser.

For example, referring to FIGS. 5 and 6, the active waveguide layer 13 has a quantum well structure, a quantum dot structure, an n-type modulation-doped quantum well structure, an n-type modulation-doped quantum dot structure, a p-type modulation-doped quantum well structure or a p-type modulation-doped quantum dot structure.

For example, wavelengths of materials and structures of the master laser and the slave laser that are provided in the embodiment of the present application are determined according to laser usage, and the substrate and the material structures are determined according to the required wavelengths. For example, to implement a high-speed directly modulated laser for optical fiber communications, a substrate of InP may be used to implement a monolithic integrated external optical injection laser. Moreover, the active waveguide layer of the monolithic integrated external optical injection laser has an InGaAsP/InGaAsP, InGaAlAs/InGaAlAs, InGaAsP or InGaAlAs quantum well structure, or may have a corresponding quantum dot structure, a p-type modulation-doped quantum well (quantum dot) structure or an n-type modulation-doped quantum well (quantum dot) structure, or may not be doped with a quantum well (quantum dot), which is not required and limited in the present application.

FIG. 7 is a structure diagram of a first total reflection mirror according to an embodiment of the present application. Referring to FIG. 7, the first total reflection mirror 4 is a formed etched tangent plane, and the etched tangent plane has an acute angle (for example, an angle of 45°) with an extension direction of the first straight waveguide 5. In the direction perpendicular to the substrate, deep etching is performed at a position of the passive waveguide layer 11 where the passive waveguide layer 11 overlaps the first total reflection mirror 4 to form a groove.

FIG. 8 is a top view of another external optical injection locked laser according to an embodiment of the present application. Referring to FIG. 8, a first straight waveguide 5 closest to the input-output waveguide 3 is a coupled straight waveguide 51, the coupled straight waveguide 51 is made of the same material as the input-output waveguide 3 and has the same structure as the input-output waveguide 3. In the embodiment of the present application, among the first straight waveguides 5 of the waveguide resonant cavity, the coupled straight waveguide 51 is manufactured by employing a passive waveguide structure, and the remaining first straight waveguides 5 are manufactured by employing an active waveguide structure. Since the coupled straight waveguide 51 is made of the same material as the input-output waveguide 3 and has the same structure as the input-output waveguide 3, high coupling efficiency, easy making and no introduction of large absorption loss are implemented for the coupled straight waveguide 51 and the input-output waveguide 3.

In an embodiment, as shown in FIG. 8, the external optical injection locked laser includes one slave laser 2. In some other embodiments, the external optical injection locked laser may also include multiple slave lasers 2, thereby improving the overall device performance of the external optical injection locked laser. In terms of improving modulation characteristics, a low-frequency roll-off effect can be effectively reduced, and a modulation bandwidth can be significantly improved.

FIG. 9 is a top view of another external optical injection locked laser according to an embodiment of the present application. Referring to FIG. 9, the external optical injection locked laser includes at least two slave lasers 2, and the at least two slave lasers 2 include a first slave laser 6 and a second slave laser 7. In a projection perpendicular to the substrate, the first slave laser 6 and the second slave laser 7 are located on two sides of the input-output waveguide 3. In the embodiment of the present application, the first slave laser 6 and the second slave laser 7 form a parallel structure.

For example, referring to FIG. 9, the input-output waveguide 3 includes a first sub-waveguide 321 and a second sub-waveguide 322. In the projection perpendicular to the substrate, the first slave laser 6 and the second slave laser 7 are located on the two sides of the first sub-waveguide 321. The second sub-waveguide 322 is located on a side of the second slave laser 7 facing away from the first sub-waveguide 321. The laser emitted by the master laser 1 is projected into the first sub-waveguide 321, coupled into the first slave laser 6 by the first sub-waveguide 321 and coupled again into the first sub-waveguide 321 via the first slave laser 6. The laser is coupled into the second slave laser 7 by the first sub-waveguide 321, coupled into the second sub-waveguide 322 by the second slave laser 7 and continues propagating in the second sub-waveguide 322.

FIG. 10 is a top view of another external optical injection locked laser according to an embodiment of the present application. Referring to FIG. 10, the input-output waveguide 3 includes a first sub-waveguide 321 and a second sub-waveguide 322. In the projection perpendicular to the substrate, the first slave laser 6 corresponds to the first sub-waveguide 321, and the second sub-waveguide 322 corresponds to the second slave laser 7. The laser emitted by the master laser 1 is projected into the first sub-waveguide 321, coupled into the first slave laser 6 by the first sub-waveguide 321 and coupled again into the first sub-waveguide 321 via the first slave laser 6. The laser is transmitted to the second sub-waveguide 322 by the first sub-waveguide 321, coupled into the second slave laser 7, coupled into the second sub-waveguide 322 via the second slave laser 7 and continues propagating in the second sub-waveguide 322.

FIG. 11 is a top view of another external optical injection locked laser according to an embodiment of the present application. Referring to FIG. 11, the external optical injection locked laser includes at least two slave lasers 2, and the at least two slave lasers 2 include a first slave laser 6 and a second slave laser 7. In the projection perpendicular to the substrate, the first slave laser 6 and the second slave laser 7 are located on the same side of the input-output waveguide 3. In the embodiment of the present application, the first slave laser 6 and the second slave laser 7 form a series structure.

FIG. 12 is a top view of another external optical injection locked laser according to an embodiment of the present application. Referring to FIG. 12, the external optical injection locked laser includes at least two slave lasers 2, and the at least two slave lasers 2 include a first slave laser 6, a second slave laser 7 and a third slave laser 17. In the projection perpendicular to the substrate, the first slave laser 6 and the second slave laser 7 are located on the same side of the input-output waveguide 3, the first slave laser 6 and the third slave laser 17 are located on the two sides of the input-output waveguide 3, and the second slave laser 7 and the third slave laser 17 are located on the two sides of the input-output waveguide 3. In the embodiment of the present application, the first slave laser 6, the second slave laser 7 and the third slave laser 17 form a series-parallel structure.

FIG. 13 is a top view of another external optical injection locked laser according to an embodiment of the present application. Referring to FIG. 13, the external optical injection locked laser further includes an optical isolator 8, and the optical isolator 8 is located in a transmission path of the input-output waveguide 3 and located between the master laser 1 and the slave laser 2. In the embodiment of the present application, the optical isolator 8 is disposed so that interference of back reflection (scatter) light of the external optical injection locked laser can be avoided and the performance of the external optical injection locked laser can be improved.

FIG. 14 is a top view of another external optical injection locked laser according to an embodiment of the present application. Referring to FIG. 14, the input-output waveguide 3 includes multiple second total reflection mirrors 16 and multiple second straight waveguides 33, and a second total reflection mirror 16 is located between two adjacent second straight waveguides 33 and configured to reflect a laser in one second straight waveguide 33 to the other second straight waveguide 33.

For example, referring to FIG. 14, the multiple second straight waveguides 33 include a first input-output sub-waveguide 331, a second input-output sub-waveguide 332 and a third input-output sub-waveguide 333. The first input-output sub-waveguide 331 and the third input-output sub-waveguide 333 extend in the X direction and are arranged in parallel. The second input-output sub-waveguide 332 extends in the Y direction, one end of the second input-output sub-waveguide 332 is connected to the first input-output sub-waveguide 331, and the other end of the second input-output sub-waveguide 332 is connected to the third input-output sub-waveguide 333. After the laser projected into the third input-output sub-waveguide 333 is reflected by the second total reflection mirror 16, the laser enters into the second input-output sub-waveguide 332 and into the first input-output sub-waveguide 331 after being reflected by the second total reflection mirror 16 again, then the laser is coupled into the first straight waveguide 5 of the slave laser 2 by the first input-output sub-waveguide 331, coupled again into the first input-output sub-waveguide 331 by the first straight waveguide 5 of the slave laser 2, and reflected into the second input-output sub-waveguide 332 by the second total reflection mirror 16 again at the end of the first input-output sub-waveguide 331. After being transmitted in the second input-output sub-waveguide 332, the laser is reflected into the third input-output sub-waveguide 333 by the second total reflection mirror 16 again and continues propagating in the third input-output sub-waveguide 333. Moreover, to improve the production quality of the total reflection mirror and reduce the loss of the total reflection mirror, the second total reflection mirrors 16 and the first total reflection mirrors 4 are designed and prepared in a staggered manner.

FIG. 15 is a top view of another external optical injection locked laser according to an embodiment of the present application. Referring to FIG. 15, multiple second straight waveguides 33 include a first input-output sub-waveguide 331 and second input-output sub-waveguides 332, and the first input-output sub-waveguide 331 and the second input-output sub-waveguides 332 are connected. The first input-output sub-waveguide 331 extends in the X direction, and the second input-output sub-waveguides 332 extend in the Y direction. In the embodiment of the present application, the laser emitted by the master laser 1 is directly projected into the second input-output sub-waveguide 332, after being reflected by the second total reflection mirror 16, the laser enters the first input-output sub-waveguide 331 and is coupled into the first straight waveguide 5 of the slave laser 2 by the first input-output sub-waveguide 331, coupled again into the first input-output sub-waveguide 331 by the first straight waveguide 5 of the slave laser 2 and reflected into the second input-output sub-waveguide 332 by the second total reflection mirror 16 at the end of the first input-output sub-waveguide 331 and continues propagating in the second input-output sub-waveguide 332. Since a small number of second total reflection mirrors 16 and second straight waveguides 33 are disposed in the embodiment of the present application, loss caused by the reflection mirror is reduced.

The simulation performance of monolithic integrated external optical injection locking high-speed directly modulated semiconductor lasers is used as an example, and the application value of the technical solution provided in the present application can be proved. As can be seen from FIG. 16, for a rectangular cavity laser, only the first total reflection mirror 4 with the power reflectivity of 89.3% or more needs to be prepared, and the internal loss of the rectangular cavity laser is lower than 38.2 cm⁻¹, which is far less than that of a circular ring laser. As can be seen from FIG. 17, as the internal loss of a ring laser increases and the length of the resonant cavity of the ring laser increases, a modulation bandwidth of the laser gradually decreases, but the lowest modulation bandwidth still exceeds 25 GHz as long as the internal loss is controlled to be less than 38.2 cm⁻¹. The laser can fully satisfy the current high-speed modulation of the laser and the use of the data communication and is an ideal light source in the field of optical communication.

## Claims

1. An external optical injection locked laser, comprising a master laser, an input-output waveguide and a slave laser that are formed on a same substrate;
wherein the master laser is configured to emit a laser to the input-output waveguide;
the input-output waveguide is configured to inject the laser emitted by the master laser into the slave laser; and
the slave laser comprises a waveguide resonant cavity, the slave laser is configured to emit a laser in response to the laser emitted by the master laser being injected into the slave laser, and the laser emitted by the slave laser is locked by the master laser.

2. The external optical injection locked laser according to claim 1, wherein the waveguide resonant cavity has a polygonal closed structure, wherein the polygonal closed structure comprises a plurality of first total reflection mirrors and a plurality of first straight waveguides, and a first total reflection mirror of the plurality of first total reflection mirrors is located between two adjacent first straight waveguides of the plurality of first straight waveguides.

3. The external optical injection locked laser according to claim 1, wherein the waveguide resonant cavity has a circular ring structure or a runway structure.

4. The external optical injection locked laser according to claim 2, wherein the waveguide resonant cavity is triangular, quadrilateral or hexagonal.

5. The external optical injection locked laser according to claim 2, wherein the input-output waveguide comprises a first waveguide portion and a second waveguide portion;
wherein in a projection perpendicular to the substrate and in a direction perpendicular to an extension direction of the input-output waveguide, the first waveguide portion overlaps the plurality of first straight waveguides, and the second waveguide portion overlaps the plurality of first total reflection mirrors; and
in the projection perpendicular to the substrate and in the direction perpendicular to the extension direction of the input-output waveguide, a distance between the first waveguide portion and the waveguide resonant cavity is less than a distance between the second waveguide portion and the waveguide resonant cavity.

6. The external optical injection locked laser according to claim 1 or 2, wherein the waveguide resonant cavity and the input-output waveguide are disposed in a same layer, or in a direction perpendicular to the substrate, the input-output waveguide is located between the substrate and the waveguide resonant cavity.

7. The external optical injection locked laser according to claim 1 or 2, wherein a first straight waveguide of the plurality of first straight waveguides closest to the input-output waveguide is a coupled straight waveguide, wherein the coupled straight waveguide is made of a same material as the input-output waveguide and has a same structure as the input-output waveguide.

8. The external optical injection locked laser according to claim 1 or 2, wherein at least two slave lasers are provided, and the at least two slave lasers comprise a first slave laser and a second slave laser;
wherein in a projection perpendicular to the substrate, the first slave laser and the second slave laser are located on two sides of the input-output waveguide.

9. The external optical injection locked laser according to claim 1 or 2, wherein at least two slave lasers are provided, and the at least two slave lasers comprise a first slave laser and a second slave laser;
wherein in a projection perpendicular to the substrate, the first slave laser and the second slave laser are located on a same side of the input-output waveguide.

10. The external optical injection locked laser according to claim 1 or 2, wherein at least two slave lasers are provided, and the at least two slave lasers comprise a first slave laser, a second slave laser and a third slave laser;
wherein in a projection perpendicular to the substrate, the first slave laser and the second slave laser are located on a same side of the input-output waveguide, and the first slave laser and the third slave laser are on two sides of the input-output waveguide.

11. The external optical injection locked laser according to claim 1 or 2, further comprising an optical isolator, wherein the optical isolator is located in a transmission path of the input-output waveguide and located between the master laser and the slave laser.

12. The external optical injection locked laser according to claim 2, wherein the input-output waveguide comprises a plurality of second total reflection mirrors and a plurality of second straight waveguides, and a second total reflection mirror of the plurality of second total reflection mirrors is located between two adjacent second straight waveguides of the plurality of second straight waveguides.
